# EUROPEAN PATENT APPLICATION

(11) **EP 3 567 637 A1**
(43) Date of publication of application: **13.11.2019**
(21) Application number: 18201353.2
(22) Date of filing: 18.10.2018
(51) Int. Cl.: H01L 31/0236, H01L 31/048

(54) **SOLAR CELL MODULE**

(30) Priority: 08.05.2018 CN 201820679678 U; 08.05.2018 CN 201820678916 U
(71) Applicant: Beijing Hanergy Solar Power Investment Co., Ltd., 101499 Beijing (CN)
(72) Inventor: GAO, Tingfei, Beijing, 101499 (CN); WANG, Chaoping, Beijing, 101499 (CN); ZHAO, Mochuan, Beijing, 101499 (CN)
(74) Representative: Nordmeyer, Philipp Werner

(57) **Abstract**

A solar cell module is provided. The solar cell module includes a photovoltaic conversion layer (3), a light-transmitting front plate (11), and a pattern structure (12) provided on the light-transmitting front plate (11). The pattern structure (12) is a light-transmitting pattern structure (12). The light-transmitting front plate (11) and the pattern structure (12) are both provided on a light receiving side of the photovoltaic conversion layer (3).

## Description

### TECHNICAL FIELD

The present disclosure relates to, but not limited to, the technical field of solar energy technology, and particularly relates to, but not limited to, a solar cell module.

### BACKGROUND

Solar cell module is a core part, as well as the most important part, of a solar power system. Existing solar cell modules are applied in a glass curtain wall to form a solar photovoltaic curtain wall so that the solar photovoltaic curtain wall has the advantages of integrating power generation, sound insulation, heat insulation, safety and decoration functions.

However, with the ever-increasing demands on the appearance and various properties of building materials, it is necessary to make improvement in the solar cell modules that may be applied to solar photovoltaic curtain walls.

### SUMMARY

The following is a summary of the subject matter described in detail in the disclosure. This summary is not intended to limit the scope of the claims.

Some embodiments of the present disclosure provides a solar cell module, including: a photovoltaic conversion layer, a light-transmitting front plate, and a pattern structure provided on the front plate, the light-transmitting front plate and the pattern structure are both provided on a light receiving side of the photovoltaic conversion layer.

In some embodiments, the solar cell module further includes a back plate; the photovoltaic conversion layer is located between the light-transmitting front plate and the back plate, the photovoltaic conversion layer is a solar cell, and the pattern structure is an anti-dazzle structure.

In some embodiments, the anti-dazzle structure is a concave-convex texture disposed on a plate surface of the light-transmitting front plate; or
the anti-dazzle structure is a texture film disposed on a plate surface of the light-transmitting front plate; or
the front plate is an embossed glass, and the anti-dazzle structure is an embossed pattern on the embossed glass.

In some embodiments, the solar cell module further includes a first adhesive layer, the solar cell is disposed on the back plate, and the light-transmitting front plate is connected to the photovoltaic conversion layer and the back plate via the first adhesive layer.

In some embodiments, the solar cell module further includes a first adhesive layer and a second adhesive layer, and the light-transmitting front plate is connected to the photovoltaic conversion layer via the first adhesive layer; and the photovoltaic conversion layer is connected to the back plate via the second adhesive layer.

In some embodiments, the first adhesive layer is a color adhesive sheet, and/or
the first adhesive layer has a thickness of 1 mm to 1.5 mm.

In some embodiments, the light-transmitting front plate is a color glass.

In some embodiments, the solar cell is a thin film solar cell.

In some embodiments, the pattern structure is a light-transmitting pattern layer, the photovoltaic conversion layer is a solar power generation layer, and the light-transmitting pattern layer and the light-transmitting front plate are stacked to form a pattern substrate;
the light-transmitting pattern layer is disposed on a surface of the light-transmitting front plate away from the solar power generation layer, or,
the light-transmitting pattern layer is disposed on a surface of the light-transmitting front plate adjacent to the photovoltaic conversion layer.

In some embodiments, the photovoltaic conversion layer is a solar power generation layer.

In some embodiments, the solar power generation layer further includes an antireflective film disposed on a light receiving side of the photovoltaic conversion layer.

In some embodiments, when the light-transmitting pattern layer is disposed on the surface of the light-transmitting front plate adjacent to the photovoltaic conversion layer, the surface of the light-transmitting front plate away from the photovoltaic conversion layer has recesses and protrusions.

In some embodiments, the solar cell module further includes a back plate disposed on a side of the photovoltaic conversion layer away from the pattern substrate; and/or
the back plate is a back plate of high polymer material or a glass back plate.

In some embodiments, the solar cell module further includes a first bonding layer and a second bonding layer, the first bonding layer is located between the pattern substrate and the photovoltaic conversion layer; and the second bonding layer is located between the photovoltaic conversion layer and the back plate; and/or
the first bonding layer and the second bonding layer each include any one or more of a PVB layer, an EVA layer, a PU layer, and a UV hydrosol layer.

In some embodiments, the solar cell module further includes a junction box disposed on a side of the back plate away from the photovoltaic conversion layer, and the back plate is provided with a connection hole, an input end of the junction box is electrically connected to an output end of the solar power generation layer via the connection hole; and/or
the junction box includes a terminal stud therein, and the photovoltaic conversion layer includes an electrode lead passing through the connection hole and connecting to the terminal stub.

Other aspects will become apparent upon reading and understanding the drawings and detailed description.

### BRIEF DESCRIPTION OF DRAWINGS

In order to explain embodiments of the present disclosure or technical solutions in related art more clearly, drawings for the description of the embodiments or the related art will now be described briefly. Obviously, the drawings described below are merely some embodiments of the present disclosure, and other drawings may be obtained by those skilled in the art based on these drawings without any creative labor.
Fig. 1 is a basic structural schematic view of a solar cell module provided by some embodiments of the present disclosure.
Fig. 2 is a structural schematic view I of a first type of solar cell module provided by some embodiments of the present disclosure.
Fig. 3 is a structural schematic view II of the first type of solar cell module provided by some embodiments of the present disclosure.
Fig. 4 is a structural schematic view III of the first type of solar cell module provided by some embodiments of the present disclosure.
Fig. 5 is a structural schematic view IV of the first type of solar cell module provided by some embodiments of the present disclosure.
Fig. 6 is structural schematic view of a second type of solar cell module provided by some embodiments of the present disclosure.
Fig. 7 is a structural schematic view I of a third type of solar cell module provided by some embodiments of the present disclosure.
Fig. 8 is a structural schematic view II of the third type of solar cell module provided by some embodiments of the present disclosure.
Fig. 9 is a structural schematic view of a fourth type of solar cell module provided by some embodiments of the present disclosure.
Fig. 10 is a structural schematic view of a fifth type of solar cell module provided by some embodiments of the present disclosure.
Fig. 11 is an exploded structural schematic view of a fifth type of solar cell module provided by some embodiments of the present disclosure.
Fig. 12 is a schematic view showing mounting of a junction box in the fifth type of solar cell module provided by some embodiments of the present disclosure.

### DETAILED DESCRIPTION

The technical solutions in the embodiments of the present disclosure will be described clearly and completely below with reference to the accompanying drawings in the embodiments of the present disclosure. Obviously, the embodiments to be described are merely a part but not all embodiments of the present disclosure. All other embodiments obtained by the ordinarily skilled in the art based on the embodiments of the present disclosure without paying any creative effort shall fall within the protection scope of the present disclosure.

It should be understood that in the description of the present disclosure, orientation or positional relationships referred by terms "central", "upper", "lower", "front", "back", "left", "right", "vertical", "horizontal", "top", "bottom", "inside", "outside" and the like are based on the orientation or positional relationship shown in the drawings, and are merely for facilitating describing the disclosure and simplifying the description, rather than indicting or implying that the device or component referred to must have a specific orientation or must be configured or operated at a specific orientation, and therefore should not be interpreted as limitations to the present disclosure.

In the related art, a solar photovoltaic curtain wall includes two pieces of glass, and a solar cell module disposed between the two pieces of glass. The solar cell module is connected to the two pieces of glass, respectively. When used in the field of construction (or building), the solar photovoltaic curtain wall may not only be used as a building material, but also convert solar energy into electric energy. Therefore, solar photovoltaic curtain wall is a building material that is energy-saving and environmentally friendly, green and pollution-free, and does not produce any greenhouse gases. However, since an external visual effect of a solar photovoltaic curtain wall formed by a crystalline silicon solar cell is pure black or cyan, the appearance of solar photovoltaic curtain walls is monotonous, which is not conducive to a wide application of solar photovoltaic curtain walls.

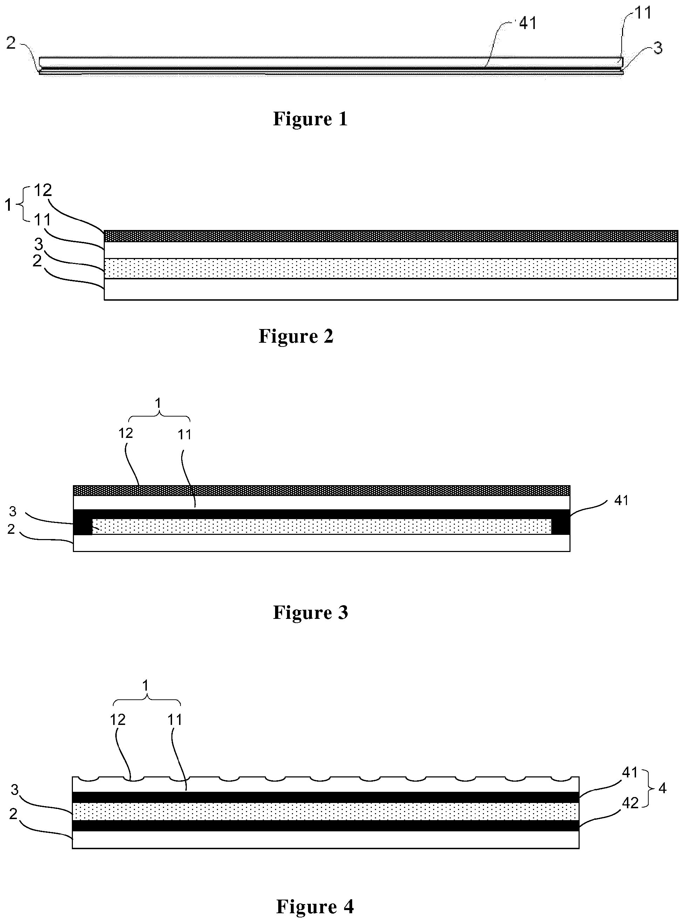

Referring to Figs. 1 and 2, in some embodiment, the solar cell module includes a photovoltaic conversion layer 3, a light-transmitting front plate 11, and a pattern structure 12 provided on the light-transmitting front plate 11. The pattern structure 12 is a light-transmitting pattern structure. The light-transmitting front plate 11 and the pattern structure 12 form a pattern substrate 1. The light-transmitting front plate 11 and the pattern structure 12 are both provided on a light receiving side of the photovoltaic conversion layer 3.

In practical applications, since the light-transmitting front plate 11 and the pattern structure 12 are both provided on the light receiving side of the photovoltaic conversion layer 3, and the pattern structure 12 is a light-transmitting pattern structure, when the solar cell module is applied to a solar photovoltaic curtain wall, sunlight irradiates on the photovoltaic conversion layer 3 through the light-transmitting front plate 11 and the pattern structure 12. The photovoltaic conversion layer 3 absorbs solar energy contained in the sunlight and converts it into electric energy. Moreover, since the light-transmitting front plate 11 and the pattern structure 12 are both disposed on the light receiving side of the photovoltaic conversion layer 3, and the pattern structure 12 is disposed on the light-transmitting front plate 11, a pedestrian may directly see the pattern set on the light-transmitting front plate 11. Thus, it is possible to use the pattern structure 12 to adjust the appearance of the solar photovoltaic curtain wall, thereby expanding the application range of the solar photovoltaic wall.

In some embodiments, as shown in Figs. 2 to 6, the above solar cell module further includes a back plate 2. The photovoltaic conversion layer 3 is located between the light-transmitting front plate 11 and the back plate 2 so that the light-transmitting front plate 11 and the back plate 2 offer protection to the photovoltaic conversion layer 3. As an example, the photovoltaic conversion layer 3 is a solar cell.

In the related art, in order to improve the conversion rate of solar energy, the solar photovoltaic curtain wall has a high light transmittance and a low diffuse reflectance, thereby, when viewed by human eyes, a problem of glare and dazzle (giddiness) tends to occur. In some embodiments, the pattern structure 12 absorbs or diffusely reflects light so that the pattern structure 12 has an anti-dazzle effect. In other words, the pattern structure 12 is an anti-dazzle structure. Based on this, when sunlight is passing through the light-transmitting front plate 11, part of the light is absorbed or diffusely reflected by the anti-dazzle structure so that the anti-dazzle structure improves the absorption ratio of sunlight by the photovoltaic conversion layer and the diffuse reflectance of the light-transmitting front plate 11. Thus, the problem of glare and dazzle to the human eyes by sunlight when looking at the solar cell module is alleviated.

The above anti-dazzle structure may be designed into various texture structures. When the solar cell module is applied to a solar photovoltaic curtain wall, the above-mentioned anti-dazzle structure designed as a texture structure also increases the decorativeness of the solar photovoltaic curtain wall so that the application range of solar photovoltaic curtain wall is further expanded.

Moreover, the texture structure is selected according to the requirements of the building where the solar photovoltaic curtain wall is applied, so as to adapt the solar photovoltaic curtain wall to different styles of external walls of the building, and ensure a coordinated style and prevent a style confliction between the solar photovoltaic curtain wall and the building where the solar photovoltaic curtain wall is applied.

In some embodiments, as shown in Fig. 4, when the anti-dazzle structure described above can be designed into various texture structures, the anti-dazzle structure is a concave-convex texture (bumpy texture) 12 disposed on a plate surface of the light-transmitting front plate 11. The concave-convex texture 12 is a stone-like texture (artificial stone vein), such as a marble-like texture or a granite-like texture. At this time, when the concave-convex texture 12 is formed on the plate surface of the light-transmitting front plate 11, the concave-convex texture and the plate surface of the light-transmitting front plate 11 are integrated.

During production of the light-transmitting front plate 11, the light-transmitting front plate 11 is produced by extrusion molding such that a surface of the light-transmitting front plate 11 forms the anti-dazzle structure. By forming the light-transmitting front plate 11 through extrusion molding, the process of producing the light-transmitting front plate 11 and the process of producing the concave-convex texture are combined into one process, thereby simplifying the manufacturing process of the solar cell module.

In some embodiments, as shown in Figs. 2, 3, 5 and 6, the anti-dazzle structure is a texture film disposed on a plate surface of the light-transmitting front plate 11. The texture film is a stone-like texture film layer. The stone-like texture film is a marble-like texture film layer, a granite-like texture film layer or the like.

The stone-like texture film layer is attached to the plate surface of the light-transmitting front plate 11 by an attaching process, so as to facilitate manufacture of the solar cell module and reduce the manufacture cost of the solar cell module. The process of attaching the stone-like texture film layer to the plate surface of the light-transmitting front plate 11 is suitable for some building external walls with a stone outer surface.

As an example, as shown in Figs. 2, 3 and 5, the above-mentioned stone-like texture film layer is attached to a surface of the light-transmitting front plate 11 away from the solar cell.

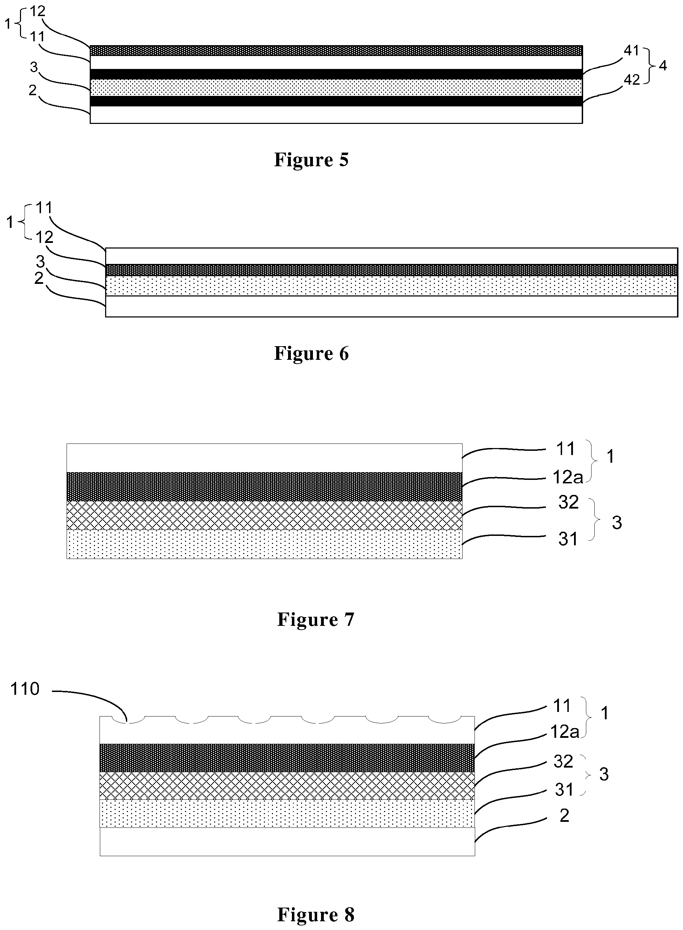

As an example, as shown in Fig. 6, the above-mentioned stone-like texture film layer is attached to a surface of the light-transmitting front plate 11 adjacent to the solar cell.

In some embodiments, given that the light-transmitting front plate 11 is typically made of glass in the related art, the light-transmitting front plate 11 is an embossed glass. The anti-dazzle structure is an embossed pattern on the embossed glass. When the light-transmitting front plate 11 is an embossed glass and the anti-dazzle structure is an embossed pattern on the embossed glass, the light-transmitting front plate 11 and the anti-dazzle structure form an integrated structure, which may help to reduce a thickness of the solar cell module so that the solar cell module tends to be lighter and thinner.

As an example, when the embossed pattern is a stone-like texture structure, the embossed pattern has a good decorative effect, which is advantageous for expanding the application range of the photovoltaic curtain wall.

In some embodiments, as shown in Figs. 1 and 3, the solar cell as the photovoltaic conversion layer 3 is disposed on the back plate 2 so that the solar cell is deposited on a surface of the back plate 2 adjacent to the light-transmitting front plate 11. The solar cell may be formed on the back plate 2 by a film forming process such as deposition or sputtering. In some embodiments, as shown in Figs. 3 to 5, the solar cell module further includes an adhesive 4. The adhesive 4 includes at least a first adhesive layer 41.

As an example, as shown in Fig. 3, if a orthogonally projected area of the solar cell on the back plate 2 is smaller than an area of the back plate 2, there will be some unused area on the surface of the back plate 2 adjacent to the light-transmitting front plate 11 when the solar cell module is formed on the surface of the back panel 2 adjacent to the light-transmitting front plate 11. At this time, the light-transmitting front plate 11 is fixedly connected to the photovoltaic conversion layer 3 and the back plate 2 via the first adhesive layer 41.

As shown in Figs. 4 and 5, if the orthogonally projected area of the solar cell on the back plate 2 is equal to the area of the back plate 2, there will be no usable area on the surface of the back plate 2 adjacent to the light-transmitting front plate 11 when the solar cell module is formed on the surface of the back panel 2 adjacent to the light-transmitting front plate 11. At this time, the adhesive 4 includes not only the first adhesive layer 41 but also a second adhesive layer 42. The solar cell is fixedly connected to the photovoltaic conversion layer 3 via the first adhesive layer 41. The photovoltaic conversion layer 3 is fixedly connected via the second adhesive layer 42.

In order to achieve a color appearance of the solar cell module, in some embodiments, as shown in Figs. 3 to 5, the first adhesive layer 41 is a color adhesive sheet. Since light may be transmitted through the light-transmitting front plate 11, a passer may see the color of the first adhesive layer 41 through the light-transmitting front plate 11. Therefore, when the first adhesive layer 41 is a color adhesive sheet, the solar cell module is a colorized solar cell module. According to the color requirements of the building facade where the solar cell module is applied, the color of the first adhesive layer 41 may be selected so that the solar cell module not only meets the color requirements of the building facade where the solar cell module is applied, but also corresponds to a color of a decorative maintenance structural part of the building, thereby increasing applicability of the solar cell module 1.

As an example, as shown in Figs. 3 to 5, the first adhesive layer 41 and the second adhesive layer 42 may be made of the same or different glue or film material. For example, the first adhesive layer 41 described above is a film made of PVB (polyvinyl butyral). In the related art, a film having a thickness of 0.76 mm is typically used to bond the light-transmitting front plate 11 to the solar cell, which has a relatively low connection strength and reliability. In order to overcome this problem, in some embodiments, the first adhesive layer 41 has a thickness of 1 mm to 1.5 mm (for example, 1.14 mm, 1.24 mm, etc.), so that the first adhesive layer 41 ensures the connection strength between the light-transmitting front plate 11 and the solar cell.

As an example, as shown in Fig. 3, the light-transmitting front plate 11 has a thickness of 6 mm, the back plate 2 and the solar cell have a total thickness of 3.2 mm, the first adhesive layer 41 is a color adhesive sheet, and the first adhesive layer 41 has a thickness of 1.14 mm. The light-transmitting front plate 11 is fixedly connected to the photovoltaic conversion layer 3 and the back plate 2 via the first adhesive layer 41, so as to ensure best connection strength between components of the solar cell module as well as a thinner state of the solar cell module.

In some embodiments, in order to achieve the colorized appearance of the solar cell module 1, the above-mentioned light-transmitting front plate 11 is a color glass. The color glass is rich in color, easy to make, beautiful in appearance and low in cost.

The solar cell used in the solar photovoltaic curtain wall in the related art is a crystalline silicon solar cell with poor resistance to deformation. In order to solve this problem, in some embodiments, the above-mentioned solar cell is a thin film solar cell. Since the thin film solar cell has advantages such as small mass, extremely thin thickness, and good bendability, it may reduce the weight and volume of the solar cell module 1 and improve the deformation resistance of the solar cell.

In some embodiments, the thin film solar cell is a silicon-based thin film solar cell, a CIGS thin film solar cell (CIGS is an abbreviation for CuInxGa(1-x)Se₂, a copper indium gallium selenide thin film solar cell) or a cadmium telluride thin film solar cell.

When the solar cell is a CIGS thin film solar cell, the solar cell has advantages such as strong light absorption capability, good power generation stability, high conversion efficiency, long power generation time during the day, high power generation, low production cost, and short energy recovery period.

In addition, in order to further enhance the appearance decorative effect of the building, a stone pattern material is required to be added to the surface of the external wall.

In the related art, stone is widely used as a high-grade building decoration material on a building surface. However, stone is a non-renewable resource, and stones reserving for decoration are limited. In order to alleviate the demand for stone, stone-like products (artificial stone products) are used instead of stones in some occasions. Currently, in the production of stone-like products, first, materials such as metal and wood are utilized for making a substrate. Then, a mineral material is utilized as a raw material of the stone-like product to form a stone-like coating with a stone effect on a surface of the substrate, thereby producing an appearance effect with a stone texture. In the related stone-like products, it is required to use a mineral material containing stone particles to make the stone-like coating. Therefore, the related stone-like products still need to consume the non-renewable stone resources to a large extent, resulting in poor environmental protection performance of the related stone-like products. Further, the related stone or stone-like products cannot be applied to the field of photovoltaic curtain wall. If a solar cell module is forcibly applied on the stone or stone-like products, the original surface of stone or stone-like products will be blocked, thereby destroying the stone or destroying the stone-like effect of the stone-like products.

In view of the above problems, in another implementation, as shown in Figs. 7 to 10, the above-mentioned pattern structure 12 is a light-transmitting pattern layer 12a. The photovoltaic conversion layer 3 includes a solar cell 31 and an antireflective film 32. The light-transmitting pattern layer 12a is stacked with the light-transmitting front plate 11. The light-transmitting pattern layer 12a and the light-transmitting front plate 11 form the pattern substrate 1. According to a relative position of the light-transmitting pattern layer 12a and the light-transmitting front plate 11, the pattern substrate 1 includes the following two types.

The first type of pattern substrate: as shown in Figs. 7 and 8, the first type of pattern substrate includes the light-transmitting pattern layer 12a and the light-transmitting front plate 11. The light-transmitting pattern layer 12a is disposed on a surface of the light-transmitting front plate 11 adjacent to the photovoltaic conversion layer 3. Since the light-transmitting pattern layer 12a is disposed on the surface of the light-transmitting front plate 11 adjacent to the photovoltaic conversion layer 3, the light-transmitting front plate 11 offers protection to the light-transmitting pattern layer 12a, thereby effectively avoiding wear of the light-transmitting pattern layer 12a due to outside rain, wind or other causes.

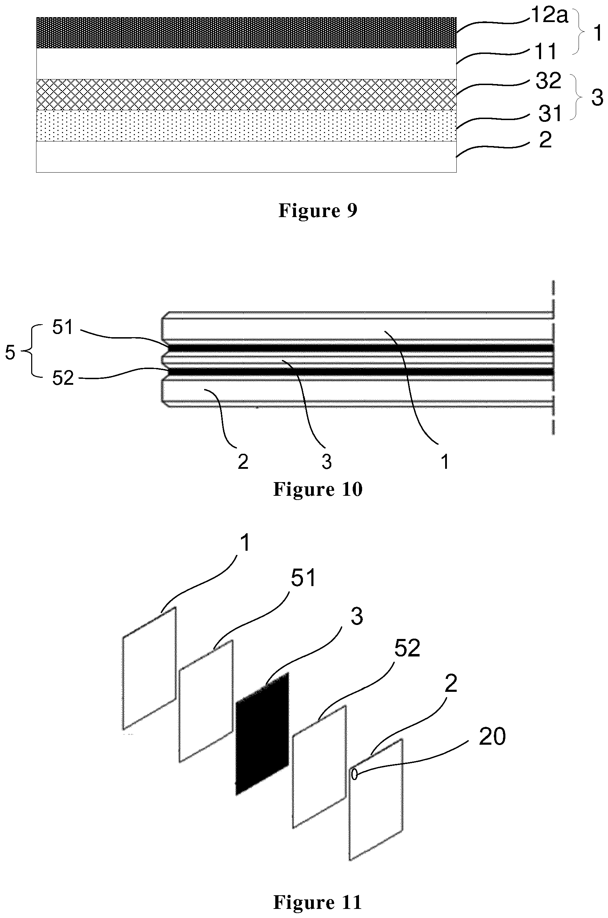

The second type of pattern substrate: as shown in Fig. 9, the second type of pattern substrate includes the light-transmitting pattern layer 12a and the light-transmitting front plate 11. The light-transmitting pattern layer 12a is disposed on a surface of the light-transmitting front plate 11 away from the photovoltaic conversion layer 3.

When the light-transmitting pattern layer 12a is applied to the light receiving side, the solar cell module is attached to the outside of a building base by means of bonding or by using a bracket. Since the light-transmitting front plate 11 and the light-transmitting pattern layer 12a are both disposed on the light receiving side of the photovoltaic conversion layer 3, the pattern substrate 1 formd by the light-transmitting pattern layer 12a and the light-transmitting front plate 11 is located on a surface of the photovoltaic conversion layer 3 away from the building base. As a result, it is ensured that external light is incident on the light receiving side of the photovoltaic conversion layer 3 through the pattern substrate 1, and the light energy is converted into electric energy via the photovoltaic conversion layer 3.

In this implementation, since the pattern structure 12 is the light-transmitting pattern layer 12a, and the light-transmitting pattern layer 12a and the light-transmitting front plate 11 are stacked to form the pattern substrate 1, when the solar cell module is applied to the outside of the building base, it is only necessary to adjust the pattern in the light-transmitting pattern layer 12a according to the appearance requirements of the building such that the light-transmitting pattern layer 12a has an effect of stone-like texture, and it is not necessary to make a stone-like coating with a mineral material. In this manner, the solar cell module not only has the appearance of a stone-like effect, but also has a power generation function.

In the related art, solar cell modules are used to construct a large-area photovoltaic array in a certain area on the ground so that the photovoltaic array is used for photovoltaic power generation. However, when the photovoltaic array are used for photovoltaic power generation, the photovoltaic array occupies a large area, resulting in low land utilization. Therefore, most relevant photovoltaic arrays are built in remote and sparsely populated areas, and are difficult to be applied in areas with a large population, which leads to certain restrictions on the application area of solar power generation.

In the above implementation, when irradiated on the surface of the solar cell module, light may pass through the pattern substrate 1 and be received by the photovoltaic conversion layer 3 to generate electricity. At the same time, the stone-like pattern of the pattern substrate 1 may be viewed from the outside. Therefore, the above solar cell module may realize solar power generation while ensuring a stone-like effect, thereby expanding the application range of the solar cell module. Thus, when the solar cell modules form a photovoltaic array for power generation, it may be used for buildings in regions such as a city with a relatively large population.

In some embodiments, the light-transmitting front plate 11 is a glass substrate or a substrate of high polymer material.

When the light-transmitting front plate 11 is a glass substrate, not only the light-transmitting front plate 11 has good light transmission performance and anti-aging ability, but also the glass material used for the light-transmitting front plate 11 is relatively easy to obtain. Thus, the light-transmitting front plate 11 may be produced on a large scale. Therefore, when the plate 11 is a glass substrate, scale production of the light-transmitting front plate 11 can be realized.

As an example, the above-mentioned glass substrate includes silica glass, organic glass or plexiglass, or a light-transmitting substrate of other materials, which is not limited herein.

In some embodiments, the light-transmitting pattern layer 12a is a metal ion coloring layer, a color glaze layer, a screen printing layer, a metal plating layer, a magnetron sputtering layer, a color adhesive film layer, or the like. The pattern in the light-transmitting pattern layer 12a may be determined according to actual needs.

As an example, the pattern in the light-transmitting pattern layer 12a is formed of metal ions of different colors, or the pattern in the light-transmitting pattern layer 12a is made up of other substances with specific colors.

In some embodiments, the pattern in the light-transmitting pattern layer 12a is a stone-like pattern. For example, the stone-like pattern is a stone block pattern or a brick wall pattern, which is not limited herein.

In order to make the stone-like effect of the solar cell module more realistic, in some embodiments, as shown in Fig. 8, when the light-transmitting pattern layer 12a is disposed on the surface of the light-transmitting front plate 11 adjacent to the photovoltaic conversion layer 3, the light-transmitting front plate 11 has recesses and protrusions 110 on a surface away from the photovoltaic conversion layer 3. These recesses or protrusions may simulate scattering, reflection or other effects similar to the stone.

As an example, the recesses and protrusions 110 are formed on the surface of the light-transmitting front plate 11 away from the light-transmitting pattern layer 12a by a process of etching or rolling.

In some embodiments, the photovoltaic conversion layer 3 includes a thin film solar cell chip layer 31. Due to a small thickness of the thin film solar cell chip layer 31, the solar cell module is made even lighter and thinner. Obviously, the photovoltaic conversion layer 3 may also be selected from other types of solar cells as long as solar power generation can be performed.

In order to improve the light utilization efficiency, in some embodiments, as shown in Figs. 7 to 9, the above-mentioned photovoltaic conversion layer 3 further includes an antireflective film 32 on the light receiving side. The antireflective film 32 is provided on the light receiving side of the thin film solar cell chip layer 31 to effectively reduce a reflectance of light irradiated onto the thin film solar cell chip layer 31, thereby improving the light utilization efficiency of the thin film solar cell chip layer 31.

In order to further improve the light utilization and to prevent light from being reflected by the pattern substrate 1, in some embodiments, the surface of the light-transmitting front plate 11 is subjected to fog face treatment such as sanding.

In some embodiments, in order to improve the structural strength of the solar cell module, as shown in Figs. 8 to 11, the solar cell module further includes a back plate 2. The back plate 2 is provided on a side of the photovoltaic conversion layer 3 away from the pattern substrate 1 so that the pattern substrate 1 and the back plate 2 both protect the solar cell chip layer, reducing direct contact of the solar cell chip layer with the outside and thus effectively avoiding damage to the solar cell chip layer.

In some embodiments, for a better appearance of the solar cell module, the back plate 2 is a glass back plate. Obviously, the back plate 2 may also be a back plate of other materials, which is not limited herein.

In some embodiments, referring to Figs. 10 and 11 again, in order to realize connection between the pattern substrate 1, the photovoltaic conversion layer 3 and the back plate 2, the solar cell module further includes a bonding layer 5. The bonding layer 5 includes a first bonding layer 51 and a second bonding layer 52. The first bonding layer 51 is located between the pattern substrate 1 and the photovoltaic conversion layer 3. The second bonding layer 52 is located between the photovoltaic conversion layer 3 and the back plate 2. The first bonding layer 51 and the second bonding layer 52 may each include one or more of a polyvinyl butyral (PVB) layer, an Ethylene-vinyl Acetate Copolymer (EVA), a polyurethane (PU) layer or an ultraviolet ray (UV) hydrosol layer.

In the production of the solar cell module described above, first, the pattern substrate 1, the first bonding layer 51, the photovoltaic conversion layer 3, the second bonding layer 52, and the back plate 2 are stacked sequentially to form a layer group to be processed. Then, the layer group to be processed is placed in a laminator, a vacuum bag, or an autoclave, and under the action of pressure or vacuum, the pattern substrate 1, the first bonding layer 51, the photovoltaic conversion layer 3, the second bonding layer 52 and back plate 2 are bonded together in sequence.

In the above embodiment, as shown in Figs. 10 and 11, the first bonding layer 51 is located between the pattern substrate 1 and the photovoltaic conversion layer 3, and the second bonding layer 52 is located between the photovoltaic conversion layer 3 and the back plate 2. As such, the impact of an external force on the back plate 2 is buffered to some extent, and the problem that the solar cell cannot generates electricity due to direct collision of the pattern substrate 1 with the photovoltaic conversion layer 3, or direct collision of the back plate 2 with the photovoltaic conversion layer 3 when the solar cell module is subjected to a slight external force is avoided.

In some embodiments, when the light-transmitting pattern layer 12a and the first bonding layer 51 are integrated, the light-transmitting pattern layer 12a may be made sticky.

As an example, in a case that the light-transmitting pattern layer 12a is sticky, when the light-transmitting pattern layer 12a is disposed on the surface of the light-transmitting front plate 11 adjacent to the photovoltaic conversion layer 3, the light-transmitting pattern layer 12a and the photovoltaic conversion layer 3 may be bonded together directly, so that the thickness of the solar cell module is reduced.

As an example, as shown in Fig. 9,in a case that the light-transmitting pattern layer 12a is sticky, when the light-transmitting pattern layer 12a is disposed on the surface of the light-transmitting front plate 11 away from the photovoltaic conversion layer 3, the light-transmitting front plate 11 and the photovoltaic conversion layer 3 are bonded together via the first bonding layer 51 therebetween.

In some embodiments, the pattern substrate 1, the photovoltaic conversion layer 3 and the back plate 2 may also be connected by riveting, by a metal frame or by other methods, which is not limited herein.

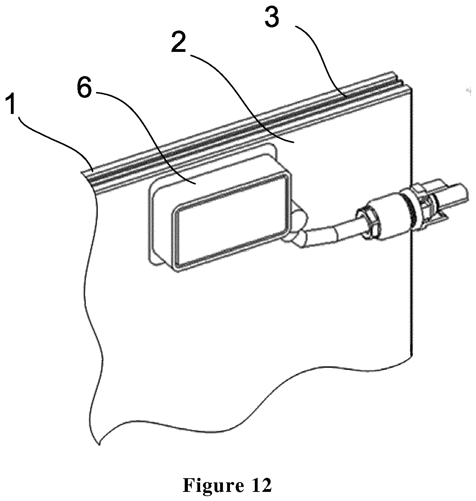

In order to draw the electric energy generated by the photovoltaic conversion layer 3 out, in some embodiments, as shown in Figs. 11 and 12, the solar cell module further includes a junction box 6. The junction box 6 is disposed on a side of the back plate 2 away from the photovoltaic conversion layer 3. The back plate 2 is provided with a connection hole 20, an input end of the junction box 6 is electrically connected to an output end of the photovoltaic conversion layer 3 via the connection hole 20.

In some embodiments, a terminal stud of the junction box 6 is used to be connected to an energy storage device or an external power grid. When the photovoltaic conversion layer 3 generates electric energy, the electric energy can be output to the energy storage device or the external power grid through the junction box 6.

The foregoing are merely specific embodiments of the present disclosure, the protection scope of the disclosure is not limited thereto. Any change or modification that can be easily thought by those skilled in the art within the technical scope disclosed by the disclosure shall fall in the protection scope of the disclosure. Therefore, the protection scope of the present disclosure shall be determined by the scope of the claims.

## Claims

1. A solar cell module, comprising a photovoltaic conversion layer (3), a light-transmitting front plate (11), and a pattern structure (12) provided on the light-transmitting front plate (11), **characterized in that**,
the light-transmitting front plate (11) and the pattern structure (12) are both provided on a light receiving side of the photovoltaic conversion layer (3).

2. The solar cell module according to claim 1, further comprising a back plate (2), **characterized in that** the photovoltaic conversion layer (3) is located between the light-transmitting front plate (11) and the back plate (2), the photovoltaic conversion layer (3) is a solar cell, and the pattern structure (12) is an anti-dazzle structure.

3. The solar cell module according to claim 2, **characterized in that** the anti-dazzle structure is a concave-convex texture disposed on a plate surface of the light-transmitting front plate (11) ; or
the anti-dazzle structure is a texture film disposed on a plate surface of the light-transmitting front plate (11) or
the light-transmitting front plate (11) is an embossed glass, and the anti-dazzle structure is an embossed pattern on the embossed glass.

4. The solar cell module according to claim 2, further comprising a first adhesive layer (41), **characterized in that** the solar cell is disposed on the back plate (2), and the light-transmitting front plate (11) is connected to the solar cell and the back plate (2) via the first adhesive layer (41).

5. The solar cell module according to claim 2, further comprising a first adhesive layer (41) and a second adhesive layer (42), **characterized in that** the light-transmitting front plate (11) is connected to the photovoltaic conversion layer (3) via the first adhesive layer (41); and the photovoltaic conversion layer (3) is connected to the back plate (2) via the second adhesive layer (42).

6. The solar cell module according to claim 4 or 5, **characterized in that** the first adhesive layer (41) is a color adhesive sheet, and/or
the first adhesive layer (41) has a thickness of 1 mm to 1.5 mm.

7. The solar cell module according to claim 1 or 2, **characterized in that**, the light-transmitting front plate (11) is a color glass.

8. The solar cell module according to any one of claims 2 to 7, **characterized in that** the solar cell is a thin film solar cell.

9. The solar cell module according to claim 1, **characterized in that** the pattern structure (12) is a light-transmitting pattern layer (12a), and the light-transmitting pattern layer (12a) and the light-transmitting front plate (11) are stacked to form a pattern substrate (1);
the light-transmitting pattern layer (12a) is disposed on a surface of the light-transmitting front plate (11) away from the photovoltaic conversion layer (3), or the light-transmitting pattern layer (12a) is disposed on a surface of the light-transmitting front plate (11) adjacent to the photovoltaic conversion layer (3).

10. The solar cell module according to claim 9, **characterized in that** the photovoltaic conversion layer is a solar power generation layer.

11. The solar cell module according to claim 10, **characterized in that** the photovoltaic conversion layer (3) further comprises an antireflective film disposed on a light receiving side of the photovoltaic conversion layer (3).

12. The solar cell module according to claim 9, **characterized in that** when the light-transmitting pattern layer (12a) is disposed on the surface of the light-transmitting front plate (11) adjacent to the photovoltaic conversion layer (3), the surface of the light-transmitting front plate (11) away from the photovoltaic conversion layer (3) has recesses and protrusions.

13. The solar cell module according to any one of claims 9 to 12, further comprising a back plate (2), **characterized in that** the back plate (2) is disposed on a side of the photovoltaic conversion layer (3) away from the pattern substrate (1); and/or
the back plate (2) is a back plate (2) of high polymer material or a glass back plate.

14. The solar cell module according to claim 13, further comprising a first bonding layer (51) and a second bonding layer (52), **characterized in that** the first bonding layer (51) is located between the pattern substrate (1) and the photovoltaic conversion layer (3); and the second bonding layer (52) is located between the photovoltaic conversion layer (3) and the back plate (2); and/or
the first bonding layer (51) and the second bonding layer (52) each comprises any one or more of a PVB layer, an EVA layer, a PU layer, and a UV hydrosol layer.

15. The solar cell module according to claim 14, further comprising a junction box (6), **characterized in that** the junction box (6) is disposed on a side of the back plate (2) away from the photovoltaic conversion layer (3), and the back plate (2) is provided with a connection hole (20), an input end of the junction box (6) is electrically connected to an output end of the solar power generation layer via the connection hole (20) ; and/or
the junction box (6) comprises a terminal stud therein, and the photovoltaic conversion layer (3) includes an electrode lead passing through the connection hole (20) and connecting to the terminal stub.
